Europäisches Patentamt

European Patent Office

Office européen des brevets

(19)

(11) Numéro de publication: **0 461 327 A2**

# (12) DEMANDE DE BREVET EUROPEEN

(21) Numéro de dépôt: 90500103.8

(22) Date de dépôt: 06.11.90

(51) Int. Cl.⁵: **G01R 31/34**

(30) Priorité: **01.06.90 ES 9001511**

(43) Date de publication de la demande:
**18.12.91 Bulletin 91/51**

(84) Etats contractants désignés:
**AT BE CH DE DK FR GB GR IT LI LU NL SE**

(71) Demandeur: **Roman Guerra, Justo**
**79, Avenue Aragon**
**E-28037 Madrid(ES)**

(72) Inventeur: **Roman Guerra, Justo**
**79, Avenue Aragon**
**E-28037 Madrid(ES)**

(74) Mandataire: **Alonso Langle, Emilio**
**12 calle Naciones**
**E-28006 Madrid(ES)**

(54) **Verificateur de rotors dans des moteurs éléctriques.**

(57) Applicable aussi bien à des moteurs à rotor bobiné qu'à ceux à rotor de cage à écureuil, il se compose d'un transformateur de tension (1) et d'un transformateur d'intensité, étant le secondaire (4) du premier branché en série au primaire (5) du second, ces bobinages définissant les bornes (7-7') de branchement du vérificateur à l'une des bobines du stator du moteur, le primaire (2) du transformateur de tension (1) étant destiné à être branché au réseau général de fourniture à travers un régulateur de tension (4) et se fermant le secondaire (8) du transformateur d'intensité (6) sur un appareil de mesure (9) qui détecte les variations possibles dans le signal de sortie, dues à des anomalies dans l'un des bobinages du rotor du moteur, lorsque l'on tourne manuellement et lentement ledit rotor de façon à ce que toutes et chacune de ses bobines passent à travers le champ magnétique créé par la bobine alimentée par le vérificateur.

L'invention dont s'agit se réfère à un vérificateur qui a été spécialement conçu pour des rotors tels que ceux utilisés dans des moteurs électriques, aussi bien dans des moteurs à rotor bobiné que si le rotor en question est de cage à écureuil, vérificateur destiné à détecter des pannes telles que l'existence de bobines en court-circuit ou de bobines ouvertes.

Il est bien évident que détecter une panne aussi bien par discontinuité que par court-circuit dans le stator d'un moteur est une tâche relativement facile pour autant que le bobinage de celui-ci soit directement accessible au travers des bornes d'alimentation correspondantes.

Il n'en n'est pas de même avec le rotor étant donné que, dans ce cas, les bobines n'ont pas de connexion avec l'extérieur et leur propre situation au sein du moteur les rend physiquement inaccessibles.

Cela suppose qu'en présence d'une hypothétique panne dans le rotor d'un moteur électrique, qu'il s'agisse d'un rotor bobiné ou d'un rotor de cage à écureuil, il est nécessaire d'"ouvrir" le moteur, avec la complexité que cette manoeuvre entraîne en conséquence et avec le risque de ce que le problème ait une autre origine, c'est à dire qu'il n'y ait pas de panne dans le rotor et que toute cette manipulation résulte superflue.

Jusqu'à présent, l'on ne connait aucune sorte de vérificateur qui soit capable de détecter l'existence ou non d'une panne dans le rotor d'un moteur sans procéder au démontage de ce rotor.

Le vérificateur que l'invention propose vient combler ce vide technologique en permettant de détecter d'une façon extrêmement rapide et simple si réellement un rotor est en panne ou non, à savoir Si ledit rotor est ouvert ou s'il présente des bobines court-circuitées.

Pour cela et de façon plus concrète, le vérificateur préconisé est structuré sur la base d'une source d'alimentation en courant alternatif et à tension variable, variation de tension effectuée à l'aide d'un régulateur, courant qui est appliqué à un transformateur de tension dont on branche au secondaire, au cours de l'utilisation du vérificateur, le bobinage du stator du moteur, le secondaire de ce transformateur étant branché en série avec le primaire d'un transformateur d'intensité, le secondaire de ce transformateur d'intensité se fermant sur un appareil de mesure.

En accord avec cette structuration et lorsqu'au secondaire du transformateur de tension on branche le bobinage du stator du moteur, comme il a été indiqué plus haut, circulera par ce bobinage un courant générateur de champ magnétique dans la zone où se trouve le rotor. Etant donné que l'intensité de ce champ magnétique est suffisamment basse pour ne pas pouvoir faire tourner le rotor, comme cela se passe dans le mouvement normal du moteur le moteur en son ensemble se met à agir comme un transformateur induisant un courant électrique dans le rotor, courant électrique qui à son tour crée une perturbation ou une modification dans le champ magnétique qui affecte l'intensité qui passe par le primaire du transformateur d'intensité et qui, à son tour, détermine un signal de sortie déterminé dans l'appareil de mesure branché au secondaire de ce transformateur d'intensité.

En faisant tourner lentement le rotor, en agissant manuel lement sur l'axe du moteur, on fait passer par le champ magnétique généré dans l'une des bobines du stator les différentes parties ou bobines du rotor et de la sorte, si elles présentent toutes des caractéristiques identiques, ce qui arrivera lorsqu'il n'y aura aucune sorte de panne ce sera que le signal de sortie de l'appareil de mesure restera invariable alors que, lorsque les caractéristiques de l'une des bobines varient, que ce soit par interruption ou par court-circuit à l'intérieur de celle-ci, ce la provoquera une modification parallèle dans le signal de sortie qui sera détectée par l'appareil de mesure, révélant ainsi clairement l'existence d'un problème dans le rotor.

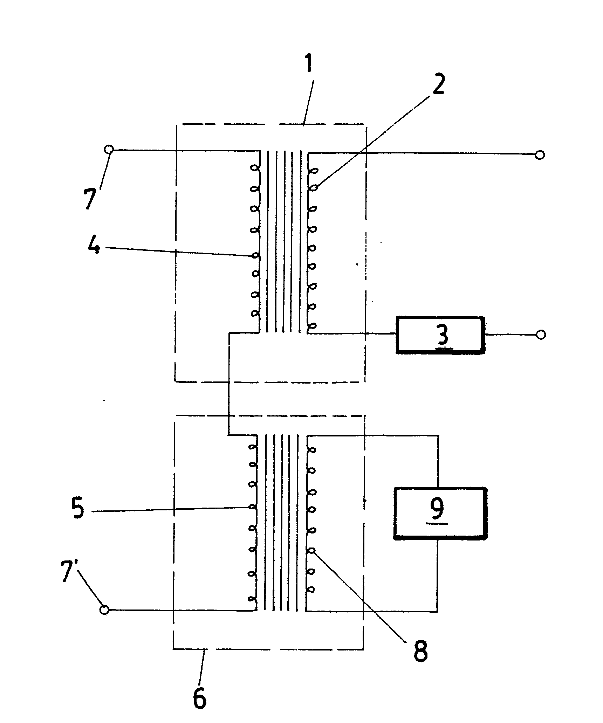

Pour complémenter la description que l'on est en train de réaliser et afin d'aider une meilleure compréhension des caractéristiques de l'invention, le présent mémoire descriptif est accompagné, faisant partie intégrante de celui-ci, d'une feuille unique de plans sur laquelle, de façon illustrée et non limitative et de par sa seule et unique figure, a été représenté schématiquement un vérificateur de rotors dans des moteurs électriques réalisé selon l'objet de la présente invention.

Au vu de cette figure, on peut observer comment le vérificateur que l'on préconise est structuré sur la base d'une source d'alimentation dans laquelle participe un transformateur de tension (1), dont le primaire (2) est branché au réseau général de la source du courant alternatif à travers un régulateur de tension (3), tandis que son secondaire (4) est branché en série au primaire (5) d'un transformateur d'intensité (6), constituant les terminaux libres (7-7') du secondaire (4) du transformateur de tension et du primaire (5) du tansformateur d'intensité, les points de branchement du vérificateur au stator du moteur, et le secondaire (8) de ce transformateur d'intensité (6) étant à son tour fermé sur un appareil de mesure (9).

Tel qu'il a été dit plus haut et en raison du courant alternatif qui accède depuis le réseau au primaire (2) du transformateur de tension (1) par le secondaire (4) de ce même transformateur circule un courant qui évidemment passe également par le primaire (5) du transformateur d'intensité (6) et par une bobine du stator du moteur lorsque l'on branche le vérificateur à cette bobine, créant ainsi, à l'intérieur du moteur, un champ magnétique qui à son tour affecte le rotor, sans puissance suffisante pour le faire tourner, et par conséquent, dans ce rotor, se produit un courant électrique qui se comporte comme secondaire d'un transformateur imaginaire, courant électrique qui à son tour crée une modification dans le champ magnétique généré par le primaire (5) du tansformateur d'intensité (6), variation de champ magnétique qui produit une augmentation de signal dans le secondaire (8) du même transformateur et celle-ci est détectée par l'appareil de mesure (9).

Naturellement, lorsque le rotor se trouve en parfaite condition, toutes ses bobines présenteront des caractéristiques identiques et par conséquent, si l'on fait tourner manuellement le rotor, les différentes bobines de celui-ci passeront par le champ magnétique généré dans la bobine du stator à laquelle se trouve accouplé le vérificateur, origineant de la sorte un signal de sortie dans l'appareil (9) qui est constant.

Si au contraire l'une des bobines du rotor se trouvait en panne, par interruption ou par court-circuit, la modification du champ magnétique due à celle-ci serait différente de celle des autres et, par conséquent, il se produirait une variation dans le signal de sortie qui serait directement détectée dans l'appareil de mesure (9) et qui décèlerait, sans l'ombre d'un doute, l'existence de cette panne dans le rotor.

Il ne semble pas nécessaire de s'étendre davantage sur cette description pour que n'importe quel expert en la matière comprenne la portée de l'invention et les avantages qui en dérivent.

Les matériaux, la forme, la dimension et la disposition des éléments seront susceptibles de variations tant que cela ne suppose pas une altération à l'essentiel de l'invention.

Les termes par lesquels a été décrit ce mémoire devront toujours être pris dans un sens large et non limitatif.

## Revendications

1.  Vérificateur de rotors dans des moteurs électriques, aussi bien dans des moteurs à rotor bobiné qu'à rotor en cage d'écureuil, caractérisé essentiellement par le fait d'être constitué au moyen de la combinaison fonctionnelle d'un transformateur de tension et d'un transformateur d'intensité, le primaire du transformateur de tension étant branché au réseau général de fourniture électrique au travers d'un régulateur de tension, alors que le secondaire de ce transformateur de tension est branché en série au primaire du transformateur d'intensité, déterminant ces deux derniers des enroulements, c'est à dire le secondaire du transformateur de tension et le primaire du transformateur d'intensité, les bornes de branchement du vérificateur à l'une des bobines du stator du moteur dont on veut vérifier le rotor; il a été prévu que le secondaire du transformateur d'intensité se ferme sur un appareil de mesure qui détecte les possibles variations du signal de sortie déterminées par des anomalies dans l'une des bobines du rotor, lorsque l'on tourne celui-ci manuellement et très lentement.